(19) Europäisches Patentamt
European Patent Office
Office européen des brevets

(11) **EP 4 050 526 A1**

(12) **EUROPEAN PATENT APPLICATION**

(43) Date of publication:
**31.08.2022 Bulletin 2022/35**

(21) Application number: **22158541.7**

(22) Date of filing: **24.02.2022**

(51) International Patent Classification (IPC):
**G06N 10/40** (2022.01)      **H01P 1/16** (2006.01)
**H01P 7/06** (2006.01)      H01P 1/211 (2006.01)

(52) Cooperative Patent Classification (CPC):
**G06N 10/40; H01P 1/16; H01P 7/06;** H01P 1/211

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.02.2021 KR 20210025123**

(71) Applicant: **Samsung Electronics Co., Ltd.**
**Gyeonggi-do, 16677 (KR)**

(72) Inventors:
• **Jang, Taehwan**
  **Suwon-si, Gyeonggi-do (KR)**

• **Kwon, Hyeokshin**
  **Suwon-si, Gyeonggi-do (KR)**
• **Shin, Jaeho**
  **Suwon-si, Gyeonggi-do (KR)**
• **Lee, Jaehyeong**
  **Suwon-si, Gyeonggi-do (KR)**
• **Jeon, Insu**
  **Suwon-si, Gyeonggi-do (KR)**
• **Han, Sungho**
  **Suwon-si, Gyeonggi-do (KR)**

(74) Representative: **Grünecker Patent- und Rechtsanwälte**
**PartG mbB**
**Leopoldstraße 4**
**80802 München (DE)**

(54) **MULTI-MODE RESONATOR AND QUANTUM COMPUTING ELEMENT INCLUDING THE SAME**

(57)    A multi-mode resonator is provided. The multi-mode resonator includes a housing and a cavity disposed in the housing, wherein the cavity includes a main cavity and a plurality of first subcavities disposed on a first lateral side of the main cavity.

FIG. 1

**Description**

BACKGROUND

1. Field

The following description relates to a multi-mode resonator and a quantum computing element.

2. Description of Related Art

Quantum computers may be defined as computing mechanisms that implement quantum mechanical phenomena such as quantum superposition and quantum entanglement as operation principles to perform data processing. A unit element (or the information itself) that stores information by using quantum mechanical principles is referred to as a quantum bit or a qubit, which may be used as a basic information unit of quantum computers.

The bit used in classical data storage devices has a state of "0" or "1," whereas a qubit may have both states of "0" and "1" simultaneously due to the superposition phenomenon. Further, due to the entanglement phenomenon, there may be interactions between qubits. According to such characteristics of qubits, N qubits may generate $2^N$ pieces of information. As a result, when the number of qubits increases, the amount of information and information processing speed may increase in an exponential function manner.

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is claimed in the independent claims. Preferred embodiments are defined in the dependent claims.

In a general aspect, a multi-mode resonator includes a housing; and a cavity disposed in the housing, wherein the cavity comprises: a main cavity; and a plurality of first subcavities disposed on a first lateral side of the main cavity.

The plurality of first subcavities may be configured to be formed along the first lateral side of the main cavity.

The main cavity may include a first area configured to have a constant width; and a second area configured to have a width which tapers along an extension direction of the main cavity.

Widths of the first subcavities on the first lateral side in the second area, among the plurality of first subcavities, may be tapered along the extension direction of the main cavity.

A pitch, Psc1, of the plurality of first subcavities may be determined to remove frequency modes adjacent to a first resonant frequency $f1_{mnl}$.

The pitch, Psc1, of the plurality of first subcavities is determined according to the following equation:

$$P_{sc}1 = \frac{k1 \cdot \pi}{\sqrt{\left(\frac{2\pi f1_{m1n1l1}}{c}\right)^2 - \left(\frac{m\pi}{Wc}\right)^2 - \left(\frac{n\pi}{Tc}\right)^2}}$$

(where Psc1: = a pitch of first subcavities, $f1_{m1n1l1}$: = a first resonant frequency, Wc = a width of the cavity, Dc = a thickness of the cavity, c = the speed of light, k1 = number of the mode group (e.g., 1, 2, 3...), Lc = a length of the cavity, m1, n1, l1 = mode number).

The cavity further may include a plurality of second subcavities disposed on a second lateral side of the main cavity, and the first lateral side and the second lateral side are located opposite to each other with respect to the main cavity.

A pitch, Psc2, of the plurality of second subcavities is determined to remove frequency modes adjacent to a second resonant frequency $f2_{mnl}$, which is different from the first resonant frequency $f1_{mnl}$, according to the following equation:

$$P_{sc}2 = \frac{k2 \cdot \pi}{\sqrt{\left(\frac{2\pi f2_{m2n2l2}}{c}\right)^2 - \left(\frac{m\pi}{Wc2}\right)^2 - \left(\frac{n\pi}{Tc2}\right)^2}}$$

, (where Psc2 = a pitch of the second subcavities, $f2_{m2n2l2}$ = a second resonant frequency, Wc = a width of the cavity, Dc - a thickness of the cavity, c - the speed of light, k2 = a number of the mode group (e.g., 1, 2, 3...), Lc = a length of the cavity, m2, n2, l2 = a mode number).

The plurality of first subcavities may be configured to be formed along the extension direction of the main cavity to be spaced apart from each other by a first distance, and the plurality of second subcavities are configured to be formed along the extension direction of the main cavity to be spaced apart from each other by a second distance, and wherein the first distance and the second distance are different from each other.

The multi-mode resonator may further include a plurality of ports configured to penetrate the housing and configured to connect to the cavity.

The main cavity may be configured to have a linear shape.

The main cavity may be configured to have a tortuous shape.

In a general aspect, a quantum computing element includes a qubit element; a storage antenna, configured to be electrically connected to the qubit element; a storage cavity, configured to surround the storage antenna; a reader antenna, configured to be electrically connected to the qubit element; and a reader cavity, configured to surround the reader antenna, wherein the storage cavity includes a main cavity; and a plurality of first subcavities disposed on a first lateral side of the main cavity.

The plurality of first subcavities may be configured to be formed along the first lateral side of the main cavity.

The main cavity may include a first area, configured to have a constant width; and a second area, configured to have a width which tapers along an extension direction of the main cavity.

A pitch, Psc1, of the plurality of first subcavities may be determined to remove frequency modes adjacent to a first resonant frequency $f1_{mnl}$ according to the following equation:

$$P_{sc}1 = \frac{k1 \cdot \pi}{\sqrt{\left(\frac{2\pi f1_{m1n1l1}}{c}\right)^2 - \left(\frac{m\pi}{Wc}\right)^2 - \left(\frac{n\pi}{Tc}\right)^2}}$$

, (where Psc1= a pitch of the first subcavities, $f1_{m1n1l1}$ = a first resonant frequency, Wc = a width of the storage cavity, Dc = a thickness of the storage cavity, c: speed of light, k1: number of mode group (e.g., 1, 2, 3...), Lc: length of the storage cavity, m1, n1, l1 = a mode number).

The storage cavity further may include a plurality of second subcavities disposed on a second lateral side of the main cavity, and the first lateral side and the second lateral side may be located opposite to each other with respect to the main cavity.

A pitch, Psc2, of the plurality of second subcavities may be determined to remove frequency modes adjacent to a second resonant frequency $f2_{mnl}$, which is different from the first resonant frequency $f1_{mnl}$, according to the following equation:

$$P_{sc}2 = \frac{k2 \cdot \pi}{\sqrt{\left(\frac{2\pi f2_{m2n2l2}}{c}\right)^2 - \left(\frac{m\pi}{Wc2}\right)^2 - \left(\frac{n\pi}{Tc2}\right)^2}}$$

, (where Psc2 = a pitch of the second subcavities, $f2_{m2n2l2}$ = a second resonant frequency, Wc = a width of the storage cavity, Dc = a thickness of the storage cavity, c = the speed of light, k2 = a number of the mode group (e.g., 1, 2, 3...),

Lc = a length of the storage cavity, m2, n2, l2 = a mode number).

The plurality of first subcavities may be configured to be formed along the extension direction of the main cavity to be spaced apart from each other by a first distance, and the plurality of second subcavities are configured to be formed along the extension direction of the main cavity to be spaced apart from each other by a second distance, and the first distance and the second distance are different from each other.

Other features and aspects will be apparent from the following detailed description, the drawings, and the claims.

BRIEF DESCRIPTION OF DRAWINGS

FIG. 1 is a perspective view of an example multi-mode resonator, in accordance with one or more embodiments.
FIG. 2 is a perspective view of a cavity of FIG. 1.
FIG. 3 is a plan view of FIG. 2.
FIG.4 is a side view of FIG. 2.
FIG. 5 is a graph illustrating modes generated in the multi-mode resonator explained with reference to FIGS. 1 to 4 when the multi-mode resonator includes only a main cavity without subcavities, in accordance with one or more embodiments.
FIG. 6 is a graph illustrating modes generated in the multi-mode resonator described with reference to FIGS. 1 to 4.
FIG. 7 is a perspective view of an example multi-mode resonator, in accordance with one or more embodiments.
FIG. 8 is a perspective view of a cavity of FIG. 7.
FIG. 9 is a plan view of FIG. 8.
FIG. 10 is a side view of FIG. 8.
FIG. 11 is another side view of FIG. 8.
FIG. 12 is a graph illustrating modes generated in the example multi-mode resonator explained with reference to FIGS. 7 to 11 when the multi-mode resonator includes only a main cavity without a plurality of first and second subcavities, in accordance with one or more embodiments.
FIG. 13 is a graph illustrating modes generated in the multi-mode resonator described with reference to FIGS. 7 to 11.
FIG. 14 is a perspective view of an example multi-mode resonator, in accordance with one or more embodiments.
FIG. 15 is a perspective view of a cavity of FIG. 14.
FIG. 16 is a perspective view of an example quantum computing element, in accordance with one or more embodiments.
FIG. 17 is a cross-sectional view illustrating a qubit chip of FIG. 16;
FIG. 18 is a perspective view of an example multi-mode resonator, in accordance with one or more embodiments.
FIG. 19 is a perspective view of a cavity of FIG. 18.
FIG. 20 is a plan view of FIG. 18.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known in the art may be omitted for increased clarity and conciseness.

The terminology used herein is for describing various examples only, and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Throughout the specification, when an element, such as a layer, region, or substrate, is described as being "on," "connected to," or "coupled to" another element, it may be directly "on," "connected to," or "coupled to" the other element, or there may be one or more other elements intervening therebetween. In contrast, when an element is described as being "directly on," "directly connected to," or "directly coupled to" another element, there can be no other elements intervening therebetween.

As used herein, the term "and/or" includes any one and any combination of any two or more of the associated listed items.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains after an understanding of the disclosure of this application. Terms, such as those defined in commonly used dictionaries, are to be interpreted as having a meaning that is consistent with their meaning in the context of the relevant art and the disclosure of the present application, and are not to be interpreted in an idealized or overly formal sense unless expressly so defined herein.

Further, the term "part" used herein refers to a unit processing at least one function or operation.

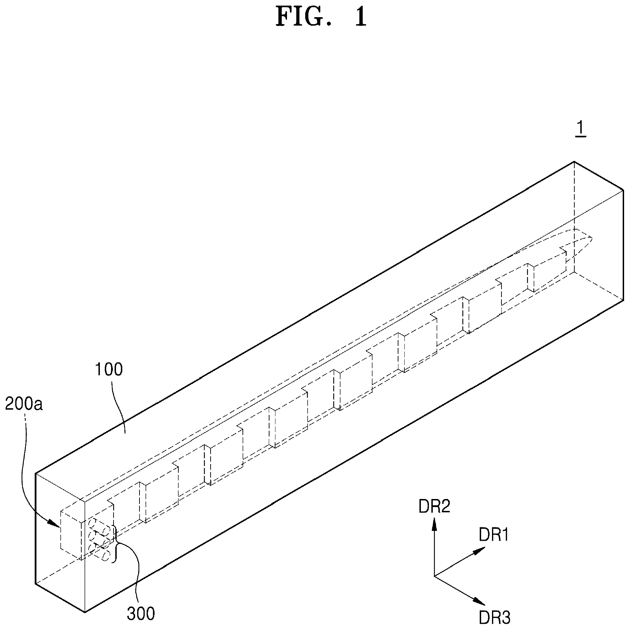

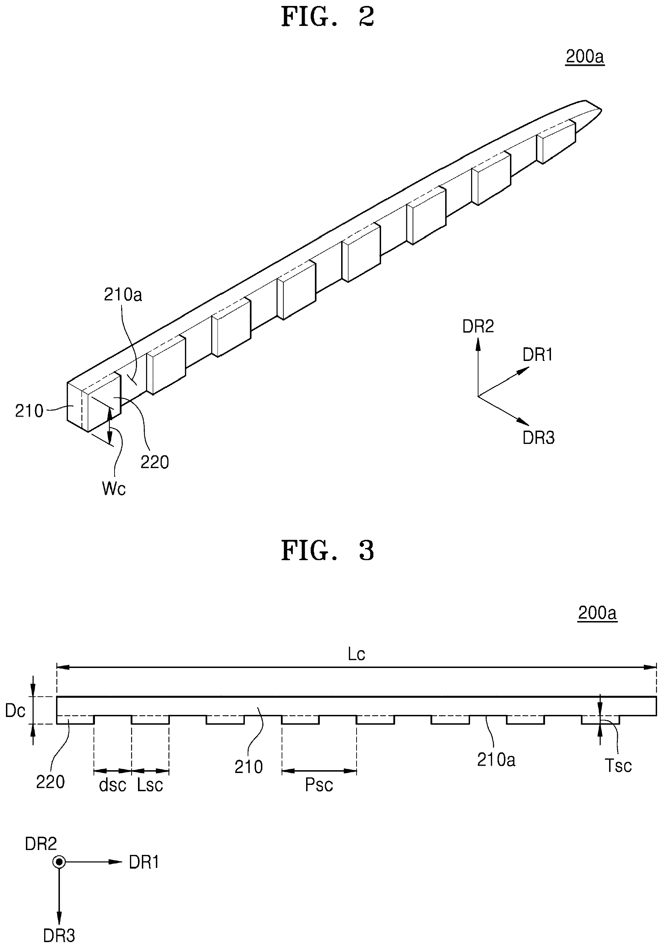

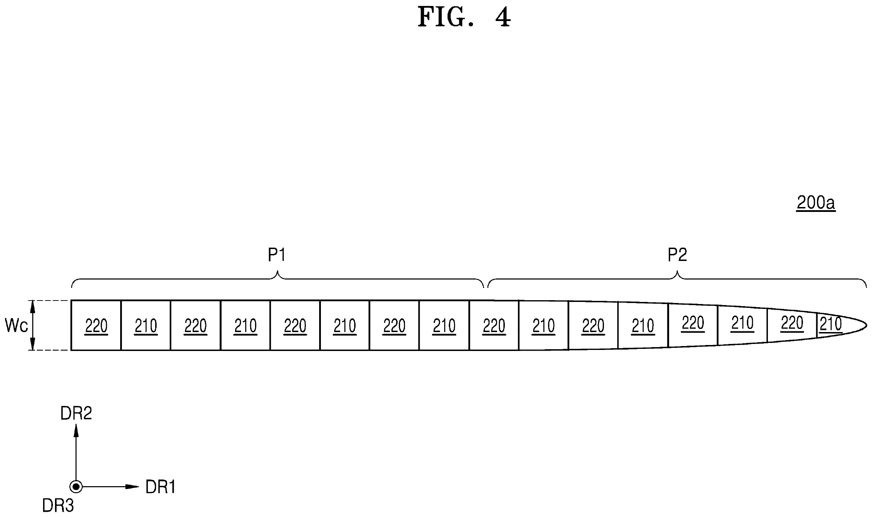

FIG. 1 is a perspective view of an example multi-mode resonator, in accordance with one or more embodiments. FIG. 2 is a perspective view of a cavity of FIG. 1. FIG. 3 is a plan view of FIG. 2. FIG. 4 is a side view of FIG. 2.

With reference to FIGS. 1 to 4, a multi-mode resonator 1 may be provided. The multi-mode resonator 1 may include a housing 100, a cavity 200a, and a plurality of ports 300. The housing 100 may prevent electromagnetic signal inflow from the outside of the housing 100 into the inside of the housing. The housing 100 may be composed of superconducting materials. In an example, the housing 100 may include aluminum (Al), niobium (Nb), indium (In), or combinations thereof. In an example, the housing 100 may be a single structure or a seamless structure which does not have a boundary surface therein. In other words, the housing 100 may be formed by processing one structure rather than combining two or more structures.

The cavity 200a may be provided in the housing 100. The cavity 200a may be an area defined by the housing 100. The cavity 200a may provide an area where high frequency signals resonate. The cavity 200a may have a length extending along a first direction DR1. The length of the cavity 200a may be referred to as a cavity length Lc. The cavity length Lc may be determined according to the configurations of various embodiments. The cavity 200a may have a width extending along a second direction DR2 which intersects the first direction DR1. The width of the cavity 200a may be referred to as a cavity width Wc. The cavity 200a may have a thickness extending along a third direction DR3 which intersects the first direction DR1 and the second direction DR2. The thickness of the cavity 200a may be referred to as a cavity thickness Dc. For example, the first direction DR1, the second direction DR2, and the third direction DR3 may be perpendicular to each other.

The cavity 200a may include a first area P1 having a constant cavity width Wc, and a second area P2 having a varying or tapered cavity width Wc. The first area P1 and the second area P2 may be formed along the first direction DR1. In an example, in the second area P2, the cavity width Wc may taper down along the first direction DR1.

The cavity 200a may include a main cavity 210 and a plurality of subcavities 220. The main cavity 210 and the plurality of subcavities 220 may be divided arbitrarily for convenience of explanation. The main cavity 210 and the plurality of subcavities 220 may constitute one interconnected cavity 200a. The main cavity 210 may extend along the first direction DR1.

The plurality of subcavities 220 may be provided on one side 210a of the main cavity 210. The plurality of subcavities 220 may be formed along the first direction DR1. In an example, the plurality of subcavities 220 may be formed at regular intervals. However, this is only an example, and the plurality of subcavities 220 may be formed at different intervals. The distance between the plurality of subcavities 220 may be referred to as a subcavity distance dsc. The plurality of subcavities 220 may have a length extending along the first direction DR1. For example, the plurality of subcavities 220 may have the same lengths. The length of each of the plurality of subcavities 220 may be referred to as a subcavity length Lsc. The sum of the subcavity length Lsc and the subcavity distance dsc may be referred to as a subcavity pitch Psc. A thickness of the subcavities 220 may be referred to as a subcavity thickness Tsc.

A plurality of modes of electromagnetic waves may be generated in the cavity 200a. Some of the modes generated in the cavity 200a may not be clearly separated, and may exist in a mixed manner. The mixed modes may be difficult to be implemented, and interference among the mixed modes may diminish the accuracy of operations.

The plurality of subcavities 220 of the examples may have a function of suppressing resonance in a predetermined frequency band (i.e., a function to suppress modes). That is, the plurality of subcavities 220 may create an environment where no resonance of electromagnetic signals occurs in a predetermined frequency band (i.e., an environment where no mode is generated). The frequency bands where resonance is suppressed may be selected by adjusting numerical values of the main cavity 210 and the plurality of subcavities 220. In an example, the cavity width Wc, maximum value of the cavity thickness Dc, cavity length Lc, and subcavity pitch Psc may be determined to suppress resonance in frequency bands adjacent to a predetermined resonant frequency ($f_{mnl}$). $f_{mnl}$ may represent a resonant frequency in an mnl mode. The subcavity pitch Psc suppressing resonance in frequency bands adjacent to the predetermined resonant frequency ($f_{mnl}$) may be determined according to the following equation:

$$P_{sc} = \frac{k\pi}{\sqrt{\left(\frac{2\pi f_{mnl}}{c}\right)^2 - \left(\frac{m\pi}{Wc}\right)^2 - \left(\frac{n\pi}{Tc}\right)^2}}$$

(Psc: pitch of subcavity, Wc: width of cavity, Dc: thickness of cavity, c: speed of light, k: number of mode group (e.g., 1, 2, 3...), Lc: length of cavity, m, n, I: mode number)

A mode group may refer to a group of modes. In an example, a mode group for a mode number "m" may be a set of modes from $f_{111}$ to $f_{1nl}$. In an example, when the cavity 200a consists only of the main cavity 210, the plurality of subcavities 220 may remove frequency bands between frequency bands where modes exist in a mixed manner (hereinafter, "non-use frequency bands") and frequency bands to be used (hereinafter, "frequency bands in use"). In this manner, the modes may be separated.

Referring again to FIG. 1, the plurality of ports 300 may be provided in the housing 100. The plurality of ports 300 may be holes penetrating the housing 100. A first end of the plurality of ports 300 may be connected to an external surface of the housing 100, and a second end of the plurality of ports 300 may be connected to the cavity 200a. In an example, the second end of the plurality of ports 300 may be connected to one of the plurality of subcavities 220. In an example, the second end of the plurality of ports 300 may be arranged at either one of both ends formed along the first direction DR1 of the cavity 200a. The plurality of ports 300 may be an area where an element configured to input high frequency signals to the multi-mode resonator 1 or output high frequency signals from the multi-mode resonator 1 is inserted. Although three ports 300 are illustrated in the drawings, this is only an example, and the present disclosure is not limited thereto. The number of ports 300 may be determined according to the determined implementation of the various embodiments.

The multi-mode resonator 1 according to the examples may separate frequency bands in use from non-use frequency bands to facilitate efficient use of modes even when the modes exist in a mixed manner and enhance computational accuracy.

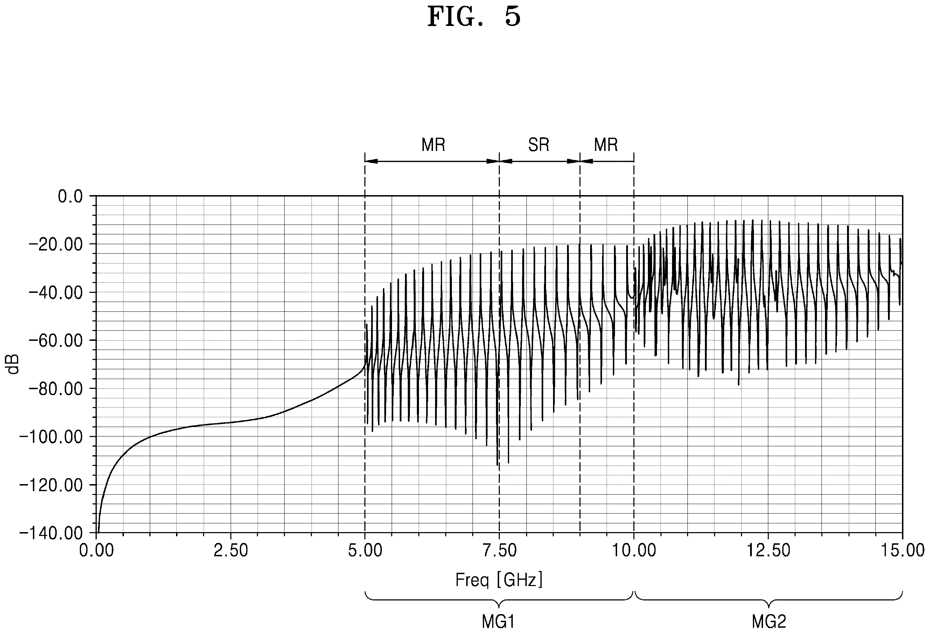

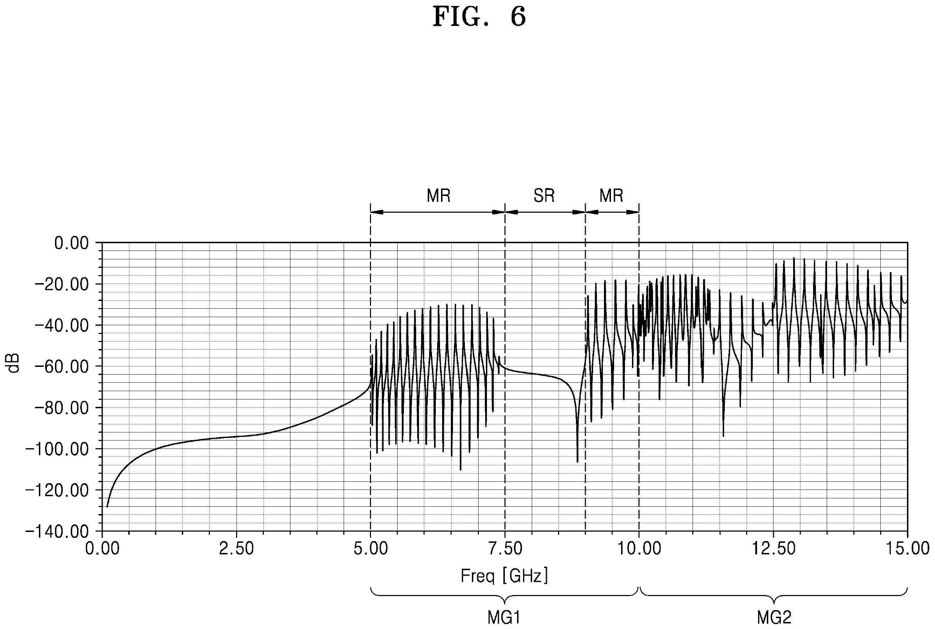

FIG. 5 is a transfer function graph illustrating modes generated in the example multi-mode resonator explained with reference to FIGS. 1 to 4 when the multi-mode resonator includes only a main cavity without subcavities. FIG. 6 is a transfer function graph illustrating modes generated in a multi-mode resonator described with reference to FIGS. 1 to 4.

With reference to FIGS. 5 and 6, modes are generated when a frequency is greater than, or equal to, approximately 5 GHz. The modes may be divided into two mode groups based on the reference frequency of approximately 10 GHz. In an example, the modes generated within a range from approximately 5 GHz to 10 GHz may be referred to as a first mode group MG1, and the modes generated within a range from about 10 GHz to 15 GHz may be referred to as a second mode group MG2.

The frequency bands from approximately 5 GHz to 7.5 GHz and from approximately 9 GHz to 10 GHz may be referred to as a mode range MR. In an example, the mode range MR may be a range in use. The frequency bands from approximately 7.5 GHz to 9 GHz may be referred to as a suppress range SR. The suppress range SR may be a non-use range.

In FIG. 5, the modes have been generated not only in the mode range MR but in the suppress range SR.

In FIG. 6, the modes have been generated only in the mode range MR. A mode has not been generated in the suppress range SR. That is, the modes have been suppressed in the suppress range SR.

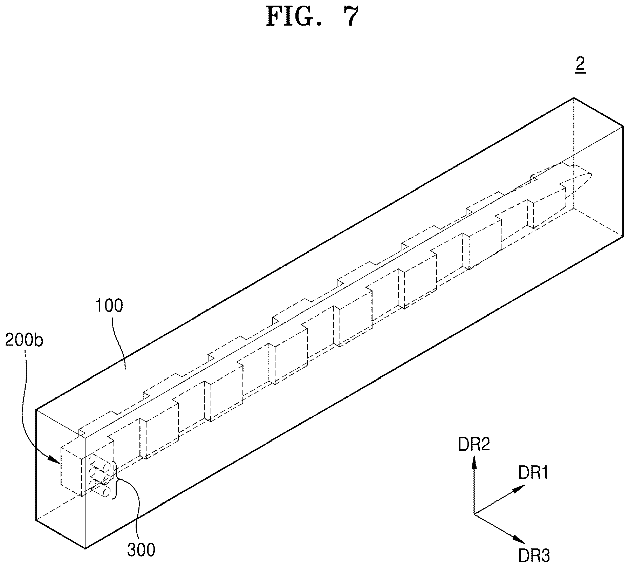

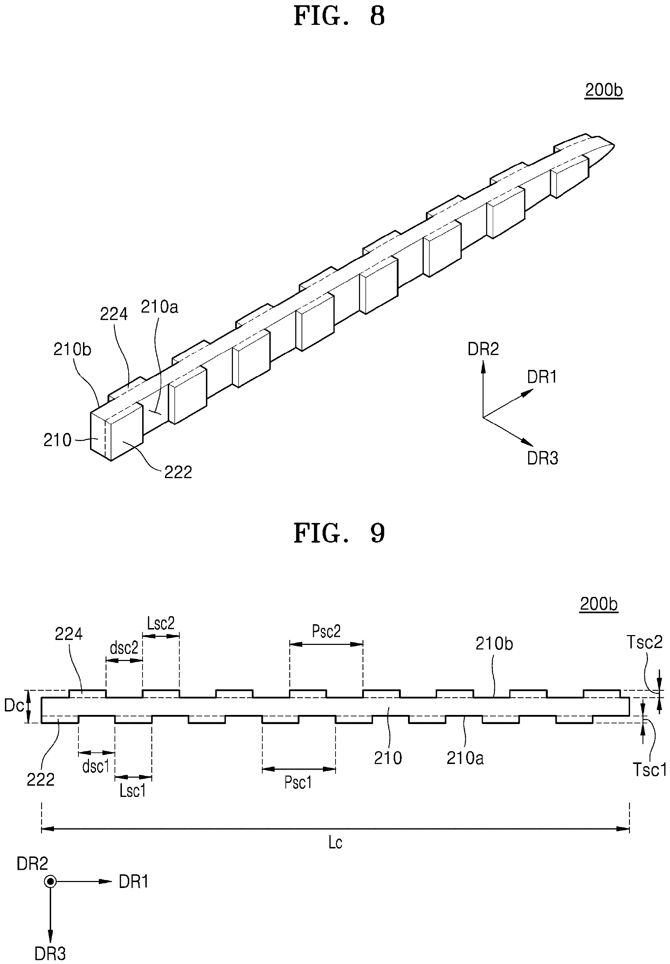

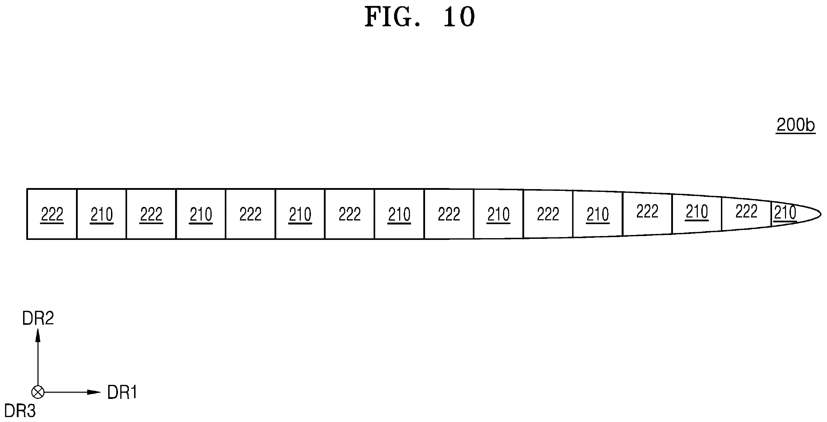

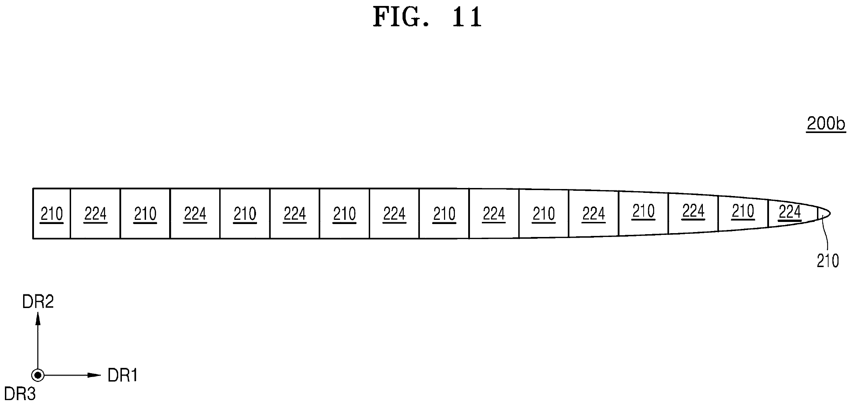

FIG. 7 is a perspective view of an example multi-mode resonator, in accordance with one or more embodiments. FIG. 8 is a perspective view of a cavity of FIG. 7. FIG. 9 is a plan view of FIG. 8. FIG. 10 is a side view of FIG. 8. FIG. 11 is another side view of FIG. 8. For the sake of concise explanation, any description substantially identical to explanations made with reference to FIGS. 1 to 4 may be omitted.

With reference to FIGS. 7 to 11, a multi-mode resonator 2 may be provided. The multi-mode resonator 2 may include a housing 100, a cavity 200b, and a plurality of ports 300. The housing 100 and the plurality of ports 300 may be substantially identical to those described with reference to FIGS. 1 to 4.

The cavity 200b may include a main cavity 210, a plurality of first subcavities 222, and a plurality of second subcavities 224. The main cavity 210 may be substantially identical to the main cavity 210 described with reference to FIGS. 1 to 4.

The plurality of first subcavities 222 may be provided on a first side 210a of the main cavity 210. The plurality of first subcavities 222 may be formed along the first direction DR1. In an example, the plurality of first subcavities 222 may be formed at regular intervals. However, this is only an example, and the plurality of first subcavities 222 may be formed at varying intervals. The distance or intervals between the plurality of first subcavities 222 may be referred to as a first subcavity distance dsc1. The plurality of first subcavities 222 may have a length extending along the first direction DR1. In an example, the plurality of first subcavities 222 may have the same lengths. However, this is only an example, and the lengths of the plurality of subcavities 222 may vary. The length of each of the plurality of first subcavities 222 may be referred to as a first subcavity length Lsc1. The sum of the first subcavity length Lsc1 and the first subcavity distance dsc1 may be referred to as a first subcavity pitch Psc1. The frequency bands where resonance is suppressed may be selected by adjusting numerical values of the main cavity 210 and the plurality of first subcavities 222. In an example, the cavity width Wc, maximum value of the cavity thickness Dc, cavity length Lc, and first subcavity pitch Psc1 may be determined to suppress resonance in frequency bands adjacent to a predetermined first resonant frequency ($f1_{m1n1l1}$). $f1_{m1n1l1}$ may represent a first resonant frequency in an mlnlll mode. The first subcavity pitch Psc1 suppressing resonance in frequency bands adjacent to the predetermined resonant frequency ($f1_{m1n1l1}$) may be determined according to the following equation:

$$Psc1 = \frac{k1 \cdot \pi}{\sqrt{\left(\frac{2\pi f1_{m1n1l1}}{c}\right)^2 - \left(\frac{m\pi}{Wc}\right)^2 - \left(\frac{n\pi}{Tc}\right)^2}}$$

$$= \frac{Lc}{l1}$$

(Psc1: pitch of first subcavities, $f1_{m1n1l1}$: first resonant frequency, Wc: width of cavity, Dc: thickness of cavity, c: speed of light, k1: number of mode group (e.g., 1, 2, 3...), Lc: length of cavity, m1, n1, l1: mode number)

The plurality of second subcavities 224 may be provided on a second side 210b of the main cavity 210. The plurality of second subcavities 224 may be formed along the first direction DR1. In an example, the plurality of second subcavities 224 may be formed at regular intervals. However, this is only an example, and the plurality of second subcavities 224 may be formed at varying intervals. The distance between the plurality of second subcavities 224 may be referred to as a second subcavity distance dsc2. The second subcavity distance dsc2 may be different from the first subcavity distance dsc1. The plurality of second subcavities 224 may have a length extending along the first direction DR1. In an example, the plurality of second subcavities 224 may have the same lengths. The length of each of the plurality of second subcavities 224 may be referred to as a second subcavity length Lsc2. The second subcavity length Lsc2 may be different from the first subcavity length Lsc1. The sum of the second subcavity length Lsc2 and the second subcavity distance dsc2 may be referred to as a second subcavity pitch Psc2. The second subcavity pitch Psc2 may be different from the first subcavity pitch Psc1. The frequency bands where resonance is suppressed may be selected by adjusting numerical values of the main cavity 210 and the plurality of second subcavities 224. For example, the cavity width Wc, maximum value of the cavity thickness Dc, cavity length Lc, and second subcavity pitch Psc2 may be determined to suppress resonance in frequency bands adjacent to a predetermined second resonant frequency ($f2_{m2n2l2}$). $f2_{m2n2l2}$ may represent a second resonant frequency in an m2n2l2 mode. The second subcavity pitch Psc2 suppressing resonance in frequency bands adjacent to a predetermined resonant frequency ($f2_{m2n2l2}$) may be determined according to the following equation:

$$Psc2 = \frac{k2 \cdot \pi}{\sqrt{\left(\frac{2\pi f2_{m2n2l2}}{c}\right)^2 - \left(\frac{m\pi}{Wc2}\right)^2 - \left(\frac{n\pi}{Tc2}\right)^2}}$$

$$= \frac{Lc}{l2}$$

(Psc2: pitch of second subcavities, $f2_{m2n2l2}$: second resonant frequency, Wc: width of cavity, Dc: thickness of cavity, c: speed of light, k2: number of mode group (e.g., 1, 2, 3...), Lc: length of cavity, m2, n2, l2: mode number)

The plurality of first subcavities 222 and the plurality of second subcavities 224 of the examples may have the first subcavity pitch Psc1 and the second subcavity pitch Psc2, respectively, which may be different from each other. The multi-mode resonator 2 of the examples may suppress resonance in each different frequency bands (e.g., frequency bands adjacent to the first resonant frequency ($f1_{m1n1l1}$) and frequency bands adjacent to the second resonant frequency ($f2_{m2n2l2}$)). When the cavity 200b includes the plurality of first subcavities 222 and the plurality of second subcavities 224, there may be one more available frequency band compared to the number of available frequency bands when the cavity 200b includes only the plurality of first subcavities 222.

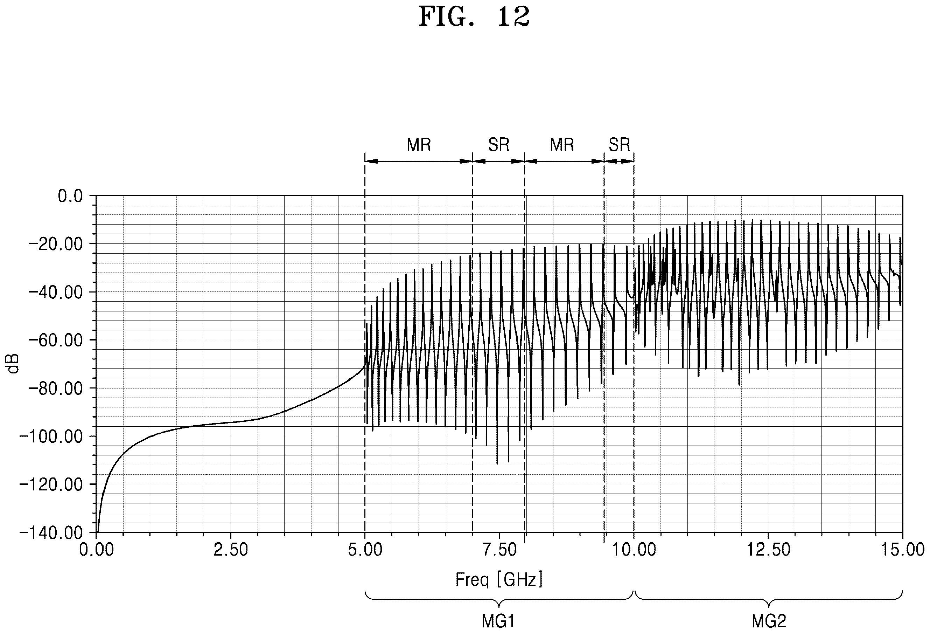

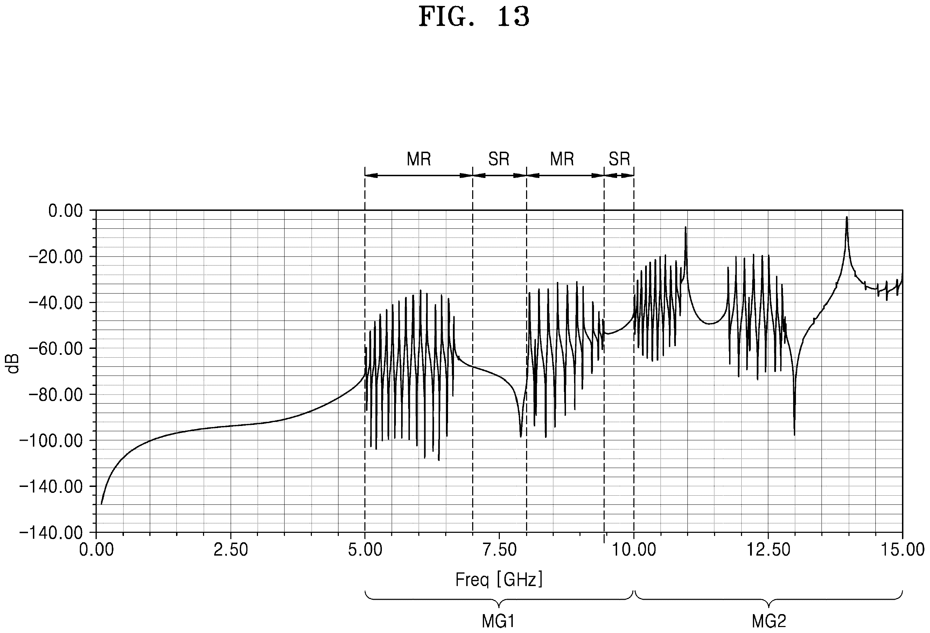

FIG. 12 is a transfer function graph illustrating modes generated in the multi-mode resonator explained with reference to FIGS. 7 to 11 when the multi-mode resonator includes only a main cavity without a plurality of first and second subcavities. FIG. 13 is a transfer function graph showing modes generated in a multi-mode resonator described with reference to FIGS. 7 to 11.

With reference to FIGS. 12 and 13, modes are generated when a frequency is greater than, or equal to, approximately 5 GHz. The modes may be divided into two mode groups based on the reference frequency of approximately 10 GHz. In an example, the modes generated within a range from about 5 GHz to 10 GHz may be referred to as a first mode group MG1, and the modes generated within a range from approximately 10 GHz to 15 GHz may be referred to as a second mode group MG2.

The frequency bands from approximately 5 GHz to 7 GHz and from approximately 8 GHz to 9.5 GHz may be referred to as a mode range MR. In an example, the mode range MR may be a range in use. The frequency bands from approximately 7 GHz to 8.5 GHz and from approximately 9.5 GHz to 10 GHz may be referred to as a suppress range SR. The suppress range SR may be a non-use range.

In FIG. 12, the modes have been generated not only in the mode range MR but in the suppress range SR.

In FIG. 13, the modes have been generated only in the mode range MR. A mode has not been generated in the suppress range SR. That is, the modes have been suppressed in the suppress range SR.

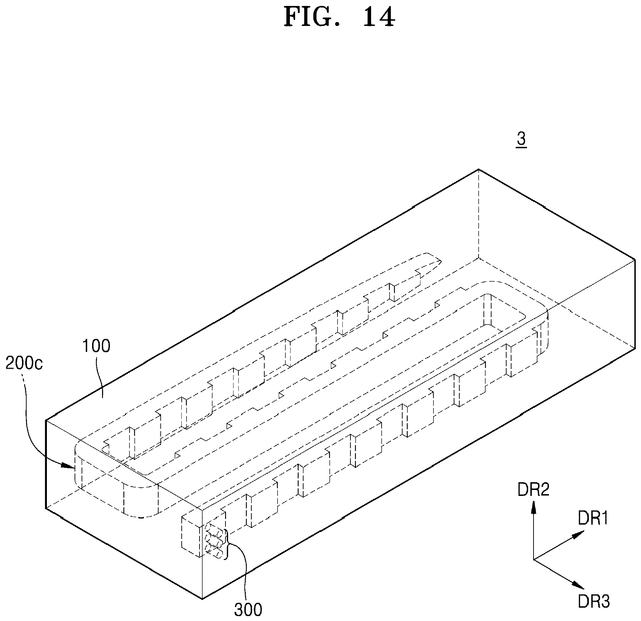

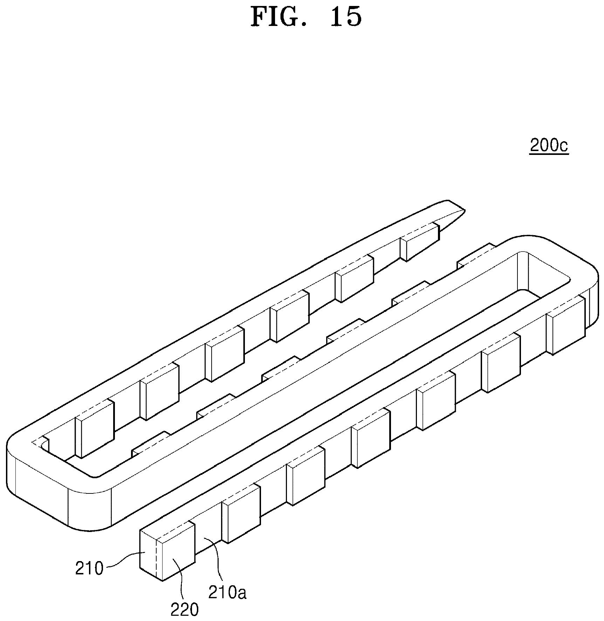

FIG. 14 is a perspective view of an example multi-mode resonator, in accordance with one or more embodiments. FIG. 15 is a perspective view of a cavity of FIG. 14. For the sake of concise explanation, any description substantially identical to explanations made with reference to FIGS. 1 to 4 may be omitted.

With reference to FIGS. 14 and 15, an example multi-mode resonator 3 is illustrated. The multi-mode resonator 3 may include a housing 100, a cavity 200c, and a plurality of ports 300. The housing 100 and the plurality of ports 300 may be substantially identical to the housing 100 and the plurality of ports 300 described with reference to FIGS. 1 to 4.

The cavity 200c may include a main cavity 200c and a plurality of subcavities 220. Unlike in FIGS. 1 to 4, the main cavity 200c may extend to have a tortuous or circuitous shape. In a non-limited example, the plurality of subcavities 220 may be provided on one side 210a of the main cavity 200c. One side 210a of the main cavity 200c may extend along an extension direction of the main cavity 200c.

The multi-mode resonator 3 may have substantially the same physical effects as the multi-mode resonator 1 described with reference to FIGS. 1 to 4. The cavity 200c having a tortuous shape may have substantially the same physical effects as the cavity 200a having a linear shape illustrated in FIGS. 1 to 4. The extension direction of the cavity 200c may be irrelevant to resonance of high frequency signals that occurs in the cavity 200c.

The multi-mode resonator 3 according to the examples may separate frequency bands in use from non-use frequency bands to facilitate efficient use of modes even when the modes exist in a mixed manner and enhance computational accuracy.

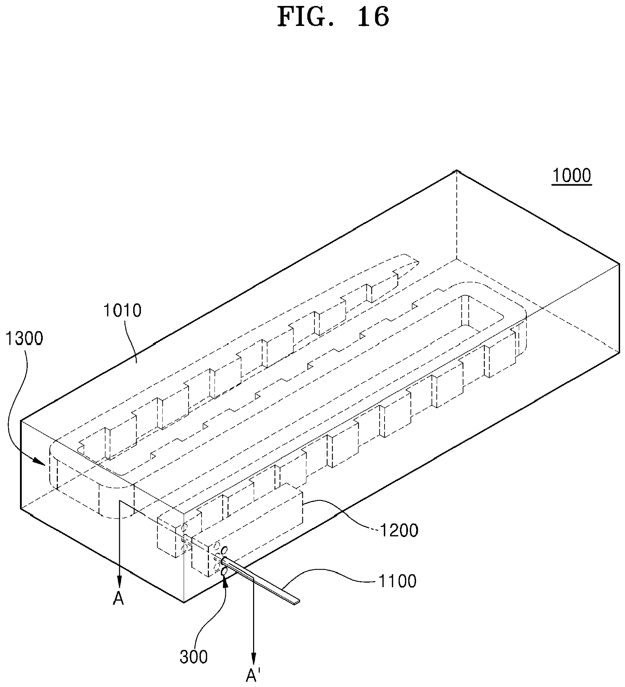

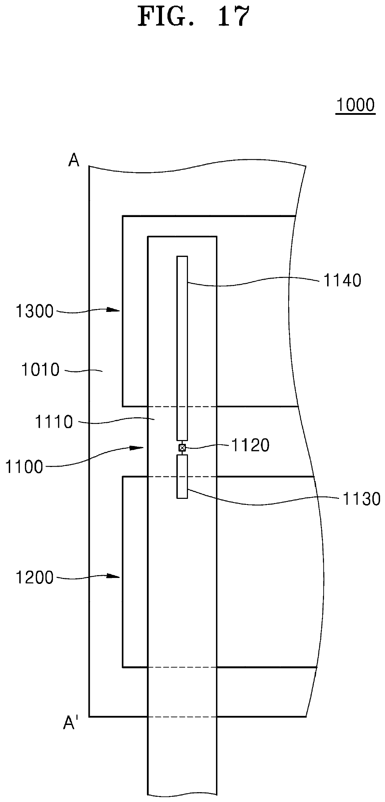

FIG. 16 is a perspective view of a quantum computing element, in accordance with one or more embodiments. FIG. 17 is a cross-sectional view for explaining a qubit chip of FIG. 16. For the sake of concise explanation, any description substantially identical to explanations made with reference to FIGS. 1 to 4, FIGS. 7 to 11 and FIGS. 14 to 15 may be omitted.

With reference to FIGS. 16 and 17, a quantum computing element 1000 is illustrated. The quantum computing element 1000 may include a qubit chip 1100, a housing 1010, a reader cavity 1200 and a storage cavity 1300. The housing 1010 may be substantially identical to the housing 100 illustrated earlier in the disclosure. The storage cavity 1300 may be substantially identical to the cavity 200c illustrated with reference to FIGS. 14 and 15. However, the examples are not limited thereto. The storage cavity 1300 may be substantially identical to the cavity 200a described with reference to FIGS. 1 to 4 or the cavity 200b described with reference to FIGS. 7 to 11. A qubit using superconductors (i.e., a superconducting qubit) may have the advantage that it can be easily manufactured into an integrated circuit.

The qubit chip 1100 may include a substrate 1110, a qubit element 1120, a reader antenna 1130, and a storage antenna 1140. The substrate 1110 may include insulating materials. For example, the substrate 1110 may include a silicon (Si) substrate or a sapphire substrate.

The qubit element 1120 may be provided on the substrate 1110. The qubit element 1120 may be an element having a nonlinear coupling. In an example, the qubit element 1120 may include a Josephson junction. The Josephson junction may include a pair of superconducting material patterns facing each other and non-superconducting patterns (e.g., a dielectric layer) inserted between the pair of superconducting material patterns. Alternatively, the Josephson junction may include a pair of superconducting material patterns facing each other and an air gap inserted between the pair of superconducting material patterns. Cooper pairs may tunnel through a Josephson junction. A Cooper pair may refer to an electron-pair which is free from electrical resistance in superconducting material patterns. A Cooper pair refers to a pair which share the same quantum state and may be represented by the same wave function.

In an example, the reader antenna 1130 may be provided on the substrate 1110. In a non-limited example, the reader antenna 1130 may be provided on one side of the qubit element 1120. The reader antenna 1130 may be capacitively coupled with a reader connector (not explicitly shown in the drawings) arranged on the reader cavity 1200. The reader connector may receive electronic signals from a device external to the quantum computing element, and convert the electronic signals into high frequency electromagnetic signals. The reader antenna 1130 may receive high frequency signals provided from the reader connector, and transmit high frequency signals to the reader connector. The reader antenna 1130 may include superconducting materials. For example, the reader antenna 1130 may include aluminum (Al), niobium (Nb), indium (In), or combinations thereof.

The storage antenna 1140 may be provided on the substrate 1110. The storage antenna 1140 may be provided on another side of the qubit element 1120. The storage antenna 1140 may be capacitively coupled with a storage connector (not explicitly shown in the drawings) arranged on the storage cavity 1300. The storage connector may receive electronic signals from a device external to the quantum computing element, and convert the electronic signals into high frequency electromagnetic signals. The storage antenna 1140 may receive high frequency signals provided from the storage connector, and transmit high frequency signals to the storage connector. The storage antenna 1140 may increase coherence time of the qubit element 1120 and may be arranged in the storage cavity 1300 to perform unitary operations. The storage antenna 1140 may include superconducting materials. For example, the storage antenna 1140 may include aluminum (Al), niobium (Nb), indium (In), or combinations thereof.

The reader cavity 1200 may surround the reader antenna 1130. In other words, the reader antenna 1130 may be arranged in the reader cavity 1200. A reader cavity 1210 may be an element configured to read qubits and increase coherence time of qubits.

The storage cavity 1300 may surround the storage antenna 1140. In other words, the storage antenna 1140 may be arranged in the storage cavity 1300. A storage cavity 1310 may be an element configured to perform unitary operations using qubits and increase coherence time of qubits.

The reader cavity 1200 and the storage cavity 1300 may be provided in the housing 1010. In the drawings, the reader cavity 1200 and the storage cavity 1300 are described as being provided in one housing 1010. However, such description is provided as an example. In another example, the quantum computing element 1000 may have each of a housing provided with the reader cavity 1200 and a housing provided with the storage cavity 1300. At this time, the housing provided with the reader cavity 1200 and the housing provided with the storage cavity 1300 may include superconducting materials, such as aluminum (Al), niobium (Nb), indium (In), or combinations thereof.

The housing 1010 may include a plurality of ports 300. In an example, some of the plurality of ports 300 may be provided between the outside of the housing 1010 and the reader cavity 1200, and others of the plurality of ports 300 may be provided between the reader cavity 1200 and the storage cavity 1300. The qubit chip 1100 may extend from the outside of the housing 1010 to the storage cavity 1300 through a port between the housing 1010 and the reader cavity 1200, and a port between the reader cavity 1200 and the storage cavity 1300. The storage connector may be arranged in the storage cavity 1300 through a port between the housing 1010 and the reader cavity 1200, and a port between the reader cavity 1200 and the storage cavity 1300. The reader connector may be arranged in the reader cavity 1200 through a port between the housing 1010 and the reader cavity 1200.

The quantum computing element 1000 including the storage resonator 1300 according to the examples may separate frequency bands in use from non-use frequency bands to facilitate efficient use of modes even when the modes exist in a mixed manner and enhance computational accuracy.

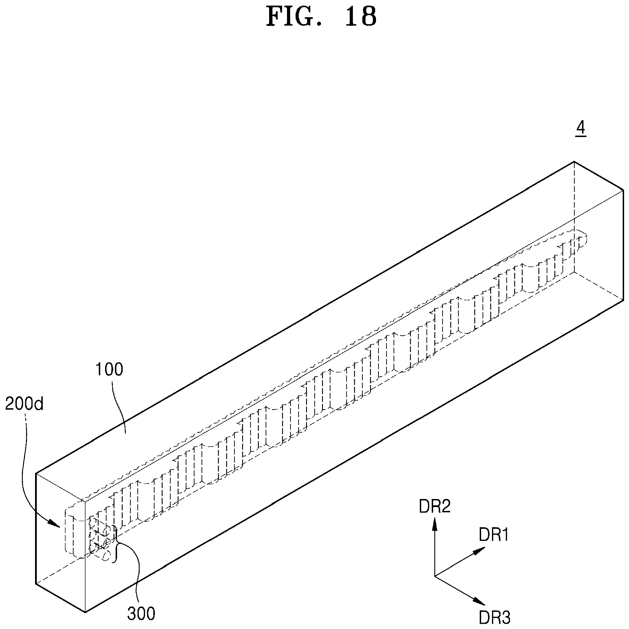

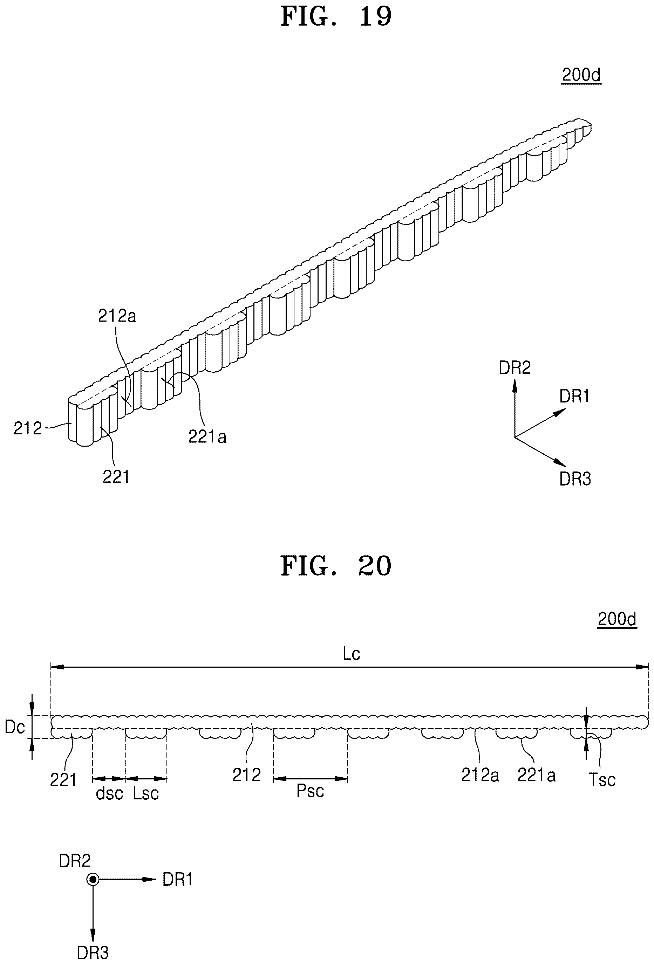

FIG. 18 is a perspective view of an example multi-mode resonator, in accordance with one or more embodiments. FIG. 19 is a perspective view of a cavity of FIG. 18. FIG. 20 is a plan view of FIG. 18. For the sake of concise explanation, any description substantially identical to explanations made with reference to FIGS. 1 to 4 may be omitted.

With reference to FIGS. 18 to 20, an example multi-mode resonator 4 is illustrated. The multi-mode resonator 4 may be substantially identical to the multi-mode resonator 1 explained with reference to FIGS. 1 to 4 except for the shape of sides of a cavity 200d.

The cavity 200d may include a main cavity 212 and a plurality of subcavities 221. The main cavity 212 and the plurality of subcavities 221 may have wave-shaped sides 212a and 221a. The wave shape of the sides 212a and 221a may extend along the second direction DR2 and include curves formed along the circumference of the cavity 200d. The wave shape of the sides 212a and 221a is not limited to descriptions in the drawings, and may be changed or modified within the scope of the technical ideas of examples by a person with ordinary skill in the art.

As explained with reference to FIGS. 1 to 4, the cavity 200d may have a cavity length Lc, cavity width Wc and cavity thickness Dc. The plurality of subcavities 220 may be formed along the first direction DR1 to be spaced from each other by a subcavity distance dsc. Each of the plurality of subcavities 220 may have a subcavity length Lsc and subcavity thickness Tsc. The sum of the subcavity length Lsc and the subcavity distance dsc may be referred to as a subcavity pitch Psc. The subcavity pitch Psc suppressing resonance in frequency bands adjacent to a predetermined resonant frequency ($f_{mnl}$) may be determined according to the following equation:

$$P_{sc} = \frac{k\pi}{\sqrt{\left(\frac{2\pi f_{mnl}}{c}\right)^2 - \left(\frac{m\pi}{Wc}\right)^2 - \left(\frac{n\pi}{Tc}\right)^2}}$$

$$= \frac{Lc}{l}$$

(Psc: pitch of subcavity, Wc: width of cavity, Dc: thickness of cavity, c: speed of light, k: number of mode group (e.g., 1, 2, 3...), Lc: length of cavity, m, n, l: mode number)

Embodiments describe the multi-mode resonator 1 explained with reference to FIGS. 1 to 4 as having wave-shaped sides; however, the cavity 200b of the multi-mode resonator 2 explained with reference to FIGS. 7 to 11 and the cavity 200c explained with reference to FIGS. 14 and 15 may also have wave-shaped sides.

The multi-mode resonator and the quantum computing element according to the examples may separate frequency bands in use from non-use frequency bands to facilitate efficient use of modes even when the modes exist in a mixed manner and enhance computational accuracy.

However, the effects of the present disclosure are not limited thereto.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims.

## Claims

1. A multi-mode resonator, comprising:

    a housing; and
    a cavity disposed in the housing,
    wherein the cavity comprises:

       a main cavity; and
       a plurality of first subcavities disposed on a first lateral side of the main cavity.

2. The multi-mode resonator of claim 1,
    wherein the plurality of first subcavities are configured to be formed along the first lateral side of the main cavity.

3. The multi-mode resonator of claim 1 or 2,
    wherein the main cavity comprises:

       a first area configured to have a constant width; and
       a second area configured to have a width which tapers along an extension direction of the main cavity,
       wherein widths of the first subcavities on the first lateral side in the second area, among the plurality of first subcavities, are tapered along the extension direction of the main cavity.

4. The multi-mode resonator of one of claims 1 to 3,
    wherein a pitch, Psc1, of the plurality of first subcavities is determined to remove frequency modes adjacent to a first resonant frequency $f1_{mnl}$, and wherein the pitch, Psc1, of the plurality of first subcavities is determined according to the following equation:

$$P_{sc}1 = \frac{k1 \cdot \pi}{\sqrt{\left(\frac{2\pi f1_{m1n1l1}}{c}\right)^2 - \left(\frac{m\pi}{Wc}\right)^2 - \left(\frac{n\pi}{Tc}\right)^2}},$$

wherein Psc1 defines a pitch of first subcavities, $f1_{m1n1l1}$ defines a first resonant frequency, Wc defines a width of the cavity, Dc defines a thickness of the cavity, c refers to the speed of light, k1 defines number of the mode group by using an integer number 1, 2, 3, ..., Lc defines a length of the cavity, and m1, n1, l1 define a mode number.

5. The multi-mode resonator of claim 4,

   wherein the cavity further comprises a plurality of second subcavities disposed on a second lateral side of the main cavity, and
   wherein the first lateral side and the second lateral side are located opposite to each other with respect to the main cavity.

6. The multi-mode resonator of claim 5,
   wherein a pitch, Psc2, of the plurality of second subcavities is determined to remove frequency modes adjacent to a second resonant frequency $f2_{mnl}$, which is different from the first resonant frequency $f1_{mnl}$, according to the following equation:

$$P_{sc}2 = \frac{k2 \cdot \pi}{\sqrt{\left(\frac{2\pi f2_{m2n2l2}}{c}\right)^2 - \left(\frac{m\pi}{Wc2}\right)^2 - \left(\frac{n\pi}{Tc2}\right)^2}},$$

wherein Psc2 defines a pitch of the second subcavities, $f2_{m2n2l2}$ defines a second resonant frequency, Wc defines a width of the cavity, Dc defines a thickness of the cavity, c refers to the speed of light, k2 defines a number of the mode group by using an integer number 1, 2, 3, ..., Lc defines a length of the cavity, and m2, n2, l2 define a mode number.

7. The multi-mode resonator of claim 5,

   wherein the plurality of first subcavities are configured to be formed along the extension direction of the main cavity to be spaced apart from each other by a first distance, and the plurality of second subcavities are configured to be formed along the extension direction of the main cavity to be spaced apart from each other by a second distance, and
   wherein the first distance and the second distance are different from each other.

8. The multi-mode resonator of one of claims 1 to 7, further comprising a plurality of ports configured to penetrate the housing and configured to connect to the cavity.

9. The multi-mode resonator of one of claims 1 to 8,
   wherein the main cavity is configured to have a linear shape or a tortuous shape.

10. A quantum computing element, comprising:

   a qubit element;
   a storage antenna, configured to be electrically connected to the qubit element;
   a storage cavity, configured to surround the storage antenna;
   a reader antenna, configured to be electrically connected to the qubit element; and
   a reader cavity, configured to surround the reader antenna,
   wherein the storage cavity comprises:

a main cavity; and
a plurality of first subcavities disposed on a first lateral side of the main cavity.

11. The quantum computing element of claim 10,
wherein the plurality of first subcavities are configured to be formed along the first lateral side of the main cavity.

12. The quantum computing element of claim 10 or 11,
wherein the main cavity comprises:

a first area, configured to have a constant width; and
a second area, configured to have a width which tapers along an extension direction of the main cavity.

13. The quantum computing element of one of claims 10 to 12,
wherein a pitch, Psc1, of the plurality of first subcavities is determined to remove frequency modes adjacent to a first resonant frequency $f1_{mnl}$ according to the following equation:

$$P_{sc}1 = \frac{k1 \cdot \pi}{\sqrt{\left(\frac{2\pi f1_{m1n1l1}}{c}\right)^2 - \left(\frac{m\pi}{Wc}\right)^2 - \left(\frac{n\pi}{Tc}\right)^2}},$$

wherein Psc1 defines a pitch of the first subcavities, $f1_{m1n1l1}$ defines a first resonant frequency, Wc defines a width of the storage cavity, Dc defines a thickness of the storage cavity, c refers to the speed of light, k1 defines a number of mode group e.g., 1, 2, 3,..., Lc defines a length of the storage cavity, and m1, n1, l1 define a mode number.

14. The quantum computing element of claim 13,

wherein the storage cavity further comprises a plurality of second subcavities disposed on a second lateral side of the main cavity, and
wherein the first lateral side and the second lateral side are located opposite to each other with respect to the main cavity.

15. The quantum computing element of claim 14,
wherein a pitch, Psc2, of the plurality of second subcavities is determined to remove frequency modes adjacent to a second resonant frequency $f2_{mnl}$, which is different from the first resonant frequency $f1_{mnl}$, according to the following equation:

$$P_{sc}2 = \frac{k2 \cdot \pi}{\sqrt{\left(\frac{2\pi f2_{m2n2l2}}{c}\right)^2 - \left(\frac{m\pi}{Wc2}\right)^2 - \left(\frac{n\pi}{Tc2}\right)^2}},$$

wherein Psc2 defines a pitch of the second subcavities, $f2_{m2n2l2}$ defines a second resonant frequency, Wc defines a width of the storage cavity, Dc defines a thickness of the storage cavity, c refers to the speed of light, k2 defines a number of the mode group e.g., 1, 2, 3, ..., Lc defines a length of the storage cavity, and m2, n2, l2 define a mode number, or
wherein the plurality of first subcavities are configured to be formed along the extension direction of the main cavity to be spaced apart from each other by a first distance, and the plurality of second subcavities are configured to be formed along the extension direction of the main cavity to be spaced apart from each other by a second distance, and the first distance and the second distance are different from each other.

# FIG. 1

# FIG. 2

200a

210a

210

220

Wc

DR2

DR1

DR3

# FIG. 3

200a

Lc

Dc

220

dsc  Lsc

210

Psc

210a

Tsc

DR2

DR1

DR3

FIG. 4

EP 4 050 526 A1

# FIG. 5

FIG. 6

# FIG. 7

# FIG. 8

200b

DR2
DR1
DR3

224  210a
210b
210
222

# FIG. 9

200b

224  Lsc2  Psc2  210b  Tsc2

dsc2

Dc

222  dsc1  210  210a  Tsc1

Lsc1  Psc1

Lc

DR2
DR1
DR3

# FIG. 10

200b

| 222 | 210 | 222 | 210 | 222 | 210 | 222 | 210 | 222 | 210 | 222 | 210 | 222 | 210 | 222 | 210 |

DR2

DR3 ⊗ → DR1

EP 4 050 526 A1

# FIG. 11

200b

| 210 | 224 | 210 | 224 | 210 | 224 | 210 | 224 | 210 | 224 | 210 | 224 | 210 | 224 | 210 | 224 |

210

DR2

DR3 → DR1

# FIG. 12

# FIG. 13

EP 4 050 526 A1

# FIG. 14

# FIG. 15

200c

210 220 210a

# FIG. 16

# FIG. 17

# FIG. 18

# FIG. 19

200d

212a

212

221

221a

DR2

DR1

DR3

# FIG. 20

200d

Lc

Dc

221

dsc  Lsc

212

Psc

212a  221a

Tsc

DR2

DR1

DR3

# EP 4 050 526 A1

**EUROPEAN SEARCH REPORT**

**Application Number**

EP 22 15 8541

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/288367 A1 (SCHUSTER DAVID [US] ET AL) 19 September 2019 (2019-09-19) | 1-3,8-12 | INV.<br>G06N10/40<br>H01P1/16<br>H01P7/06 |
| A | * paragraphs [0075] - [0086], [0089] - [0096], [0103] - [0105]; figures 1-11,14-18 * | 4-7, 13-15 | |
| X | JP 2020 096030 A (NIPPON TELEGRAPH & TELEPHONE) 18 June 2020 (2020-06-18) | 1,2,8,9 | ADD.<br>H01P1/211 |
| Y | * paragraphs [0003], [0008], [0014] - [0040]; figures 1,2,5-13 * | 10,11 | |
| A | | 4-7, 13-15 | |
| Y | XU Y ET AL: "Single-loop realization of arbitrary non-adiabatic holonomic single-qubit quantum gates in a superconducting circuit", ARXIV.ORG, CORNELL UNIVERSITY LIBRARY, 201 OLIN LIBRARY CORNELL UNIVERSITY ITHACA, NY 14853, 20 April 2018 (2018-04-20), XP081551196, DOI: 10.1103/PHYSREVLETT.121.110501 | 10,11 | |
| A | * page 2, right-hand column, paragraph 2nd; figure 1c * | 4-7, 13-15 | **TECHNICAL FIELDS SEARCHED (IPC)**<br><br>H01P<br>G06N |

The present search report has been drawn up for all claims

| Place of search | Date of completion of the search | Examiner |
|---|---|---|
| The Hague | 30 June 2022 | Georgiadis, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 15 8541

This annex lists the patent family members relating to the patent documents cited in the above-mentioned European search report.
The members are as contained in the European Patent Office EDP file on
The European Patent Office is in no way liable for these particulars which are merely given for the purpose of information.

30-06-2022

| Patent document cited in search report | | Publication date | Patent family member(s) | | Publication date |
|---|---|---|---|---|---|
| US 2019288367 | A1 | 19-09-2019 | US 2019288367 | A1 | 19-09-2019 |
| | | | US 2021184329 | A1 | 17-06-2021 |
| JP 2020096030 | A | 18-06-2020 | JP 2020096030 | A | 18-06-2020 |
| | | | US 2022029259 | A1 | 27-01-2022 |
| | | | WO 2020121815 | A1 | 18-06-2020 |

EPO FORM P0459

For more details about this annex : see Official Journal of the European Patent Office, No. 12/82